# EUROPEAN PATENT SPECIFICATION

(11) **EP 4 187 591 B1**
(45) Date of publication and mention of the grant of the patent: **01.01.2025**
(21) Application number: 21210720.5
(22) Date of filing: 26.11.2021
(51) Int. Cl.: H01L 23/367, H01L 23/473, F28F 3/04, F28F 13/18

(54) **BASEPLATE AND METHOD FOR MANUFACTURING A BASEPLATE FOR A POWER MODULE AND SEMICONDUCTOR DEVICE**
GRUNDPLATTE UND VERFAHREN ZUR HERSTELLUNG EINER GRUNDPLATTE FÜR EIN LEISTUNGSMODUL UND HALBLEITERBAUELEMENT
PLAQUE DE BASE ET PROCÉDÉ DE FABRICATION D'UNE PLAQUE DE BASE POUR UN MODULE DE PUISSANCE ET DISPOSITIF SEMI-CONDUCTEUR

(43) Date of publication of application: 31.05.2023
(73) Proprietor: Hitachi Energy Ltd, 8050 Zürich (CH)
(72) Inventor: FISCHER, Fabian, 5400 Baden (CH); BEYER, Harald, 5600 Lenzburg (CH); SANTOLARIA, Lluis, 4600 Olten (CH); MALEKI, Milad, 5417 Untersiggenthal (CH); GUILLON, David, 8857 Vorderthal (CH)
(74) Representative: Epping - Hermann - Fischer

(56) References cited:
- WO-A1-2014/064450
- WO-A1-2020/196331
- WO-A2-2013/184210
- US-A1- 2005 092 007
- US-A1- 2007 069 373
- US-A1- 2015 008 574
- US-B1- 6 729 383

## Description

The present disclosure is related to a baseplate for a power module and a method for manufacturing a baseplate for a power module. The present disclosure is further related to a corresponding semiconductor device.

Power modules are used in automotive filed for example and require a reliable and efficient cooler to dissipate heat during operation. Such coolers are fixed to power modules and guide a coolant to cool the power module.

Document WO2020/196331 discloses a cooling structure of the present invention is provided with a resin flow-path-forming member which forms a flow path through which a refrigerant circulates; and a cooling fin in which at least a surface provided extending from an inside wall of the flow path into the flow path is made out of resin, wherein a surface roughness Ra of a portion of the cooling fin which comes in contact with the refrigerant is 10 µm or more.

There is a need to provide a baseplate for a power module that contributes to effective and efficient heat dissipation during operation of the power module.

Embodiments of the disclosure relate to a baseplate for a power module which enables reliable heat dissipation. Embodiments of the disclosure also relate to a corresponding manufacturing method for such a baseplate and a corresponding semiconductor device.

According to an embodiment, a baseplate for a power module comprises a lower part with a cooling structure that is configured to be in contact with a coolant during operation of the power module. The lower part can comprise the cooling structure or can completely form the cooling structure itself. The baseplate further comprises an upper part that is coupled to the lower part. The cooling structure faces away from the upper part and comprises a surface with a given surface structure including a mean roughness Ra > 1 µm and a plurality of protrusions with a rectangular or triangular edged shape with respect to a cross section perpendicular to a surface normal and with a respective height of 2 µm or more with respect to the surface normal perpendicular to the surface of the cooling structure. The cooling structure comprises a plurality of cooling pin-fins and/or cooling ribs and the given surface structure is formed on one or more of the pin-fins or the ribs. Additionally, the cooling structure can comprise other surface structures, which may improve the cooling efficiency. The given surface structure is also formed on a bottom surface of the upper part of the baseplate which faces the lower part. For instances, the baseplate is realized as a pin-fin baseplate comprising a plurality of cooling pin-fins. The upper part can be realized by the plate-like baseplate and the lower part can be realized by the plurality of cooling pin-fins. The given surface structure in form of a minimum mean roughness Ra > 1 µm and a plurality of protrusions with a respective height of 2 µm or more can be formed on an outer surface of the pin-fins and/or between the pin-fins on the bottom surface of the upper part of the baseplate.

By use of the described configuration a baseplate an improved thermal behavior is feasible due to the specific modification of the surface of the cooling structure. The cooling structure can be formed with a plurality of pin-fins or ribs and/or other surface structures, which may improve the cooling efficiency, comprising the aforementioned given mean roughness and protrusions on their surface to contribute to reliable heat dissipation during operation of the power module.

The roughness is a property of the surface of the baseplate or its cooling structure on its lower part that can be quantified by deviations in the direction of the normal vector of a real surface from its ideal form. The mean roughness value Ra relates to the mean distance of a measuring point - on the surface - to a center line. The center line intersects the real profile within the reference section in such a way that the sum of the profile deviations in a plane parallel to the center line is distributed over the length of the measuring section. Thus, the mean roughness corresponds to the arithmetic mean of the absolute deviation from the mean line.

Power modules with strong heat generation due to losses during operation of power semiconductor devices need a reliable and sufficient heat dissipation in order to avoid excessive temperature. This can be achieved by mounting of the power module comprising the described baseplate as its lower portion to one or more openings of a cavity of a cooler for direct liquid cooling. So the backside of the baseplate for the power module which corresponds to the lower part with the cooling structure gets in direct contact with the coolant, which is a strong shortening of the thermal path because of no need of a cooler top plate. An additional thermal interface between flat baseplate and cooler top plate could cause a comparably poor thermal resistance.

By use of the baseplate comprising a pin-fins or ribs cooling structure further improvement of heat dissipation can be achieved instead of a flat baseplate. The array of multiple cooling fins or ribs enlarges on one the hand the effective area between the lower part of the baseplate and the streaming coolant. On the other hand, the multiple cooling fins or ribs are disturbing the flow of the coolant, and helping the generation of a turbulent flow, so that turbulent instead of laminar flow is generated, resulting in even larger heat dissipation.

It is a recognition in connection with the present disclosure that conventional concepts of baseplates for power modules deal with the velocity and kind of the coolant and the geometry of the cooling interface. The cooling portion of such baseplates typically are formed relatively flat without any significant roughness. A heat transition, e.g. between baseplate backside and the coolant is determined by the heat transition coefficient between the two partners, i.e. between the baseplate backside part and the coolant. This parameter is not only related to the materials themselves or the kind of coolant flow, but determined by different mechanical parameters. It is a recognition in connection with the present disclosure that also the surface structure of the cooling portion can have a significant influence on the thermal behaviour and thus the amount of heat which can be dissipated. By use of protrusions and a predetermined minimum mean roughness the heat transition coefficient can be influenced noticeably providing a clear potential for further thermal improvement and providing further enhancement of cooling efficiency for a baseplate having cooling structures like fins or ribs. The rough surface of the cooling structure of the described baseplate presents a possibility to enhance the heat-transfer efficiency in turbulent thermal convection.

The aforementioned structures on the one hand contribute to increase the heat exchange area, and on the other hand support nucleate boiling (in case of two phase) and provide wall roughness which supports turbulence near the wall and therefore enhance heat exchange. Such improvements due to better heat dissipation allows for higher current capability, size reduction by less total active area of chips, higher reliability due to reduced heating of devices. When using the proposed structure of the pin-fins or ribs, there is on one hand a larger thermal interface (surface), and on the other hand an improvement of turbulent flow is enabled. The heat and/or flow related parameters contributes to improvement in the performance of the power module as a whole.

According to a further embodiment of the baseplate, the given surface structure comprising a mean roughness Ra > 1 µm is formed by means of at least one of etching, grinding, sandblasting and laser irradiation. Thus, a suitably rough surface structure can be prepared to beneficially affect the heat dissipation for the power module. Other methods of preparation of roughness of a desired surface structure are possible as well. The given surface structure can realize a rough, corrugated and/or irregular surface structure, a porous structure and/or a dendritic structure. The dendritic structure might comprise a needle shape surface of randomly placed needles distributed over the surface of the cooling structure. For example, dendritic, porous, or needle shaped structures may be related to a coating attached to the upper part and/or lower part.

According to a further embodiment of the baseplate, the given surface structure comprises a coating such that the coated surface of the cooling structure comprises the mean roughness Ra > 1 µm. The coating can partially or completely cover the cooling structure in form of pin-fins or ribs, for example. The coating can comprise particles and/or a porous material, dendrite-like structures and/or irregular needle shaped to provide the minimum mean roughness RA > 1 µm. The coating can be made of nickel as an example and/or may form a layer that have a thickness in the micron range of maximum 50 µm, for example. Nickel can contribute to corrosion prevention for the cooling structure due to its contact to liquid coolant. Thus, the desired roughness and/or protruding surface structures can be prepared by a coating and/or by machining of the surface of cooling structure on the lower part and optionally the flat portions of baseplate backside realized by the bottom surface of the upper part.

According to a further embodiment of the baseplate, the given surface structure can be modified by comprising a plurality of protrusions with a respective height of 2 µm or more, wherein a pitch or a distance between respective centers of two adjacent protrusions has a value of 10 µm or more with respect to a lateral direction perpendicular to the surface normal. Alternatively, the distance of the pitch can have a value of 15 µm, 20 µm, 25 µm, 30 µm, 40 µm, 50 µm up to 100 µm or more. Moreover, the height of the protrusions can be the same or different from the others. The height can have a value of 3 µm, 4 µm, 5µm up to 10 µm or more, alternatively. Such protrusions can be applied to a coating or to a bulk material and methods for preparation of regular structures are provided by etching or laser structuring.

The distance may represent a spacing between the outer surfaces of the protrusions facing each other. The pitch may represent a distance between the centers of the protrusions next to each other. One or more protrusions can be formed with a round shape or other regular shapes with respect to a cross section perpendicular to the surface normal. Moreover, other applicable shapes of the protrusions are possible as well, which are suited to improve the cooling efficiency. The surface normal is orientated in a direction corresponding to the height of the protrusion and perpendicular to the lateral adjacent surface the protrusion is extending from. The protrusions can be formed regularly or irregularly distributed over the surface of the cooling structure according to its purpose, e.g. different density of population. The protrusions have a reproducible regular shape, for example.

According to a further embodiment of the baseplate, the given surface structure comprises at least one of a mean roughness Ra > 2 µm and a plurality of protrusions with a respective height of 4 µm or more. Alternatively, the mean roughness Ra can comprise a value more than 3 µm, 4 µm, 5 µm up to 10 µm or more.

The baseplate material can be made of copper or comprise copper or copper alloy, aluminum or aluminum alloy. Alternatively, the baseplate can be made of or comprise a composite material like aluminum silicon carbide (AlSiC) or magnesium silicon carbide (MgSiC).

According to an embodiment, a semiconductor power module comprises an embodiment of the described baseplate and electronics that is coupled to the upper part of the baseplate. The baseplate can form a component of the power module or the baseplate can form an insert or an additional component attached to the power module. The electronics may include chips, integrated circuits and/or other discrete devices, switching elements like IGBTs or power MOSFETs and/or diodes.

According to an embodiment, a method for manufacturing an embodiment of the described baseplate comprises providing the lower part with the cooling structure that is configured to be in contact with a coolant during operation of the power module. The method further comprises providing the upper part coupled to the lower part, and forming the given surface structure on the surface of the cooling structure such that it includes at least one of a mean roughness Ra > 1 µm and a plurality of protrusions with a rectangular or triangular edged shape with respect to a cross section perpendicular to a surface normal and with a respective height of 2 µm or more with respect to the surface normal perpendicular to the surface of the cooling structure.

Forming of the given surface structure on the cooling structure can comprise machining the surface by means of at least one of etching, grinding, sandblasting and laser irradiating. Alternatively or additionally, forming the given surface structure on the cooling structure can comprise machining the surface by means of coating the surface partially or completely with a given coating material such that the coated surface comprises a mean roughness Ra > 1 µm.

As a result of that the described semiconductor device and the described manufacturing method comprise or are related to produce an embodiment of the baseplate, described features and characteristics of the baseplate are also disclosed with respect to the semiconductor device and the manufacturing method and vice versa.

The described rough surfaces comprising given mean roughness and/or specifically designed protrusions realize a beneficial way to enhance the heat-transfer efficiency in turbulent thermal convection or to provide turbulent convection at least locally in a laminar flow. Thus, the implementation of a rough or corrugated structure and/or protruding structures on the surfaces of cooling fins of a pin-fin baseplate can provide an improvement of the heat transfer coefficient and the heat dissipation. The surface modifications can be implemented to the cooling pin-fins of the pin-fin baseplate themselves. Additionally, also the surfaces of flat portions of the bottom side of the upper part of the pin-fin baseplate may be modified as well.

The implementation or formation of the given surface structure can be done by coating the surface with any material providing a rough structure and/or by any method of surface machining. On one hand an enlargement of the effective surface area of the cooling fins or cooling structure is achieved. On the other hand a rough surface structure supports the supports the generation of more effective turbulent coolant flow due to an increase of the turbulence intensity, which improves the mixing capacity of the flow and therefore the heat exchange.

A main benefit is directly related to the purpose of the invention of an improved heat dissipation of the power module due to a rough and/or corrugated surface of the cooling structures and a consequent reduction of the thermal resistance. This may be used for different optional improvements:
- Higher possible heat dissipation resulting in a higher current capability of the power module without any further design changes
- Lower losses when operating power semiconductor devices at lower temperature
- Longer lifetime w.r.t. power cycling (especially power cycling especially with long cycle times e.g. of 60 seconds) due to smaller thermal swings at same current and applied power as before.

Additionally, a surface modification by coating may provide an improved protection of the cooling structure, but also of the baseplate backside or the bottom side of the upper part against corrosion and abrasive wear. The described configurations of the baseplate are applicable for all power modules in a direct cooling application.

Exemplary embodiments are explained in the following with the aid of schematic drawings and reference numbers. The figures show:
- Figure 1: an embodiment of a baseplate for a power module in a side view;
- Figure 2: an embodiment of a surface structure of the baseplate in an enlarged side view;
- Figures 3-4: embodiments of a surface structure of the baseplate in respective side views; and
- Figure 5: a flow chart for a method for manufacturing an embodiment of the baseplate for the power module.

The accompanying figures are included to provide a further understanding. It is to be understood that the embodiments shown in the figures are illustrative representations and are not necessarily drawn to scale. Identical reference numbers designate elements or components with identical functions. In so far as elements or components correspond to one another in terms of their function in the figures, the description thereof is not repeated for each of the following figures. For the sake of clarity elements might not appear with corresponding reference symbols in all figures possibly.

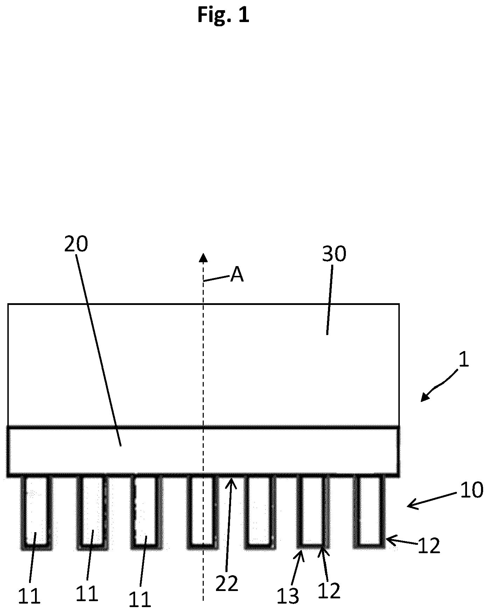

Figure 1 illustrates a side view of an embodiment of a baseplate 1 for a power module 30 for a semiconductor device, for example. The baseplate 1 comprises a lower part 10 with a cooling structure including a plurality of ribs or pin-fins 11 that are configured to be in contact with a coolant during operation of the power module 30. The baseplate 1 further comprises an upper part 20 that is coupled to the lower part 10 and is configured to be coupled to the power module 30 or to form a bottom component of the power module 30. Thus, the baseplate 1 can form a part of the power module 30 itself or can form an insert of a cooler, where power module 30 with flat backside of substrate, diepad, or baseplate is mounted on it. The baseplate 1 forms a bottom component of or for the power module 30.

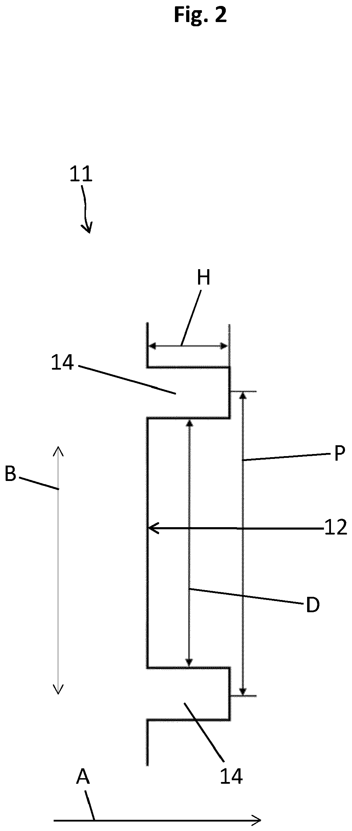

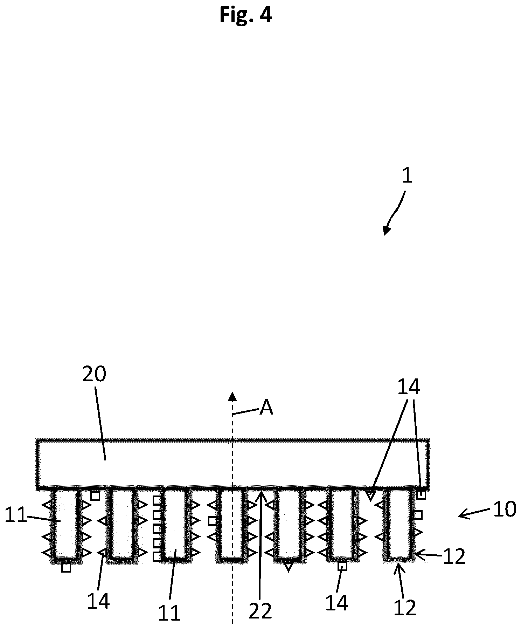

The cooling structure faces away from the upper part 20 and comprises a surface 12 with a given surface structure including a mean roughness Ra > 1 um and/or a plurality of protrusions 14 with a respective height H of 2 um or more with respect to a surface normal A perpendicular to the surface 12 of the cooling structure and its pin-fins 11 (see Fig. 2). Thus, Fig. 1 shows a pin-fin baseplate 1 indicating the cooling pin-fins 11 with a modified surface and flat backside parts there between, which may optionally have a modified surface, too (see Fig. 4).

The given surface structure can be realized as a coating 13 which partially or completely covers the pin-fins 11 (see Fig. 1). A coated surface may be machined for preparation of structures in addition to the opportunity of a rough coating 13 itself. Alternatively or additionally, the given surface structure can comprise a plurality of protrusions 14 with a respective minimum height H of 2 µm extending from the surface 12 of the pin-fins 11 and/or a bottom side 22 of the upper part 20 (see Figs. 2-4).

Figure 2 shows an enlarged view of a pin-fin 11 and two protrusions 14 extending outwardly. Such protrusions 14 can have a cylindrical, an elliptical, a cuboid or a pyramidal shape. Thus, with respect to a cross section perpendicular to the drawn direction of the surface normal A the protrusions 14 can have a round, a rectangular or triangular shape. The surface normal A may be perpendicular to a lateral or longitudinal extension direction B of the pin-fins 11. A distance D may present the closest spacing between two adjacent protrusions 14. A pitch P may present the spacing between the centers of the two adjacent protrusions 14. The distance D or the pitch P may have a value between 5-100 um, for example 5 um, 10 µm or 20 um. The height H may have a value between 1-10 um, for example 1 um, 2 um or 5 um.

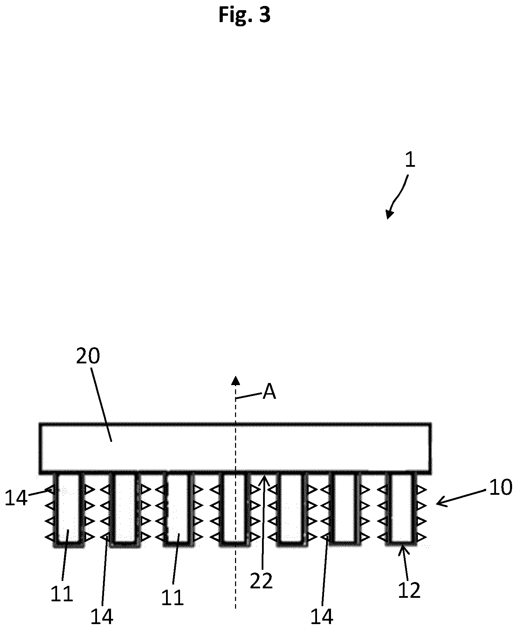

The surface 12 represents the outer surface of the cooling structure and its cooling pin-fins 11. Thus, the surface 12 realizes a bottom surface of the pin-fins 11 facing away from the upper part 20 and also realizes a circumferential surface of the pin-fins 11 up to the bottom surface 22 of the upper part. The protrusions 14 and/or the coating 13 can be formed on the bottom surface 12 and/or the circumferential surface 12 of the pin-fins 11 and/or the bottom surface 22 partially or completely to provide a desired roughness of the cooling structure (see Figs. 1-4). Figures 3 and 4 illustrates different shapes and/or possible positions of the regularly and irregularly distributed protrusions 14.

The deliberately introduced surface structure on the surface 12 and/or 22 leads to a roughness that enhances the heat-transfer efficiency in turbulent thermal convection or provides turbulent convection at least locally in a laminar flow, and hence contributes to reliable dissipation of heat during operation of the associated power module 30. Even if the structures are formed to have a mean roughness Ra in the micrometer range > 1 um in a microchannel of e.g. 100 um thickness that result in a significant enhancement of the Nusselt Number Nu, which is directly proportional to the convective heat transfer coefficient, and an increase of the pressure drop of the coolant due to an increase of the friction factor. For example, a formation of local turbulent flow due to protruding structures having a height H of 4 um and a pitch P of 32 um, especially, if the protrusions 14 have triangular or rectangular shape can efficiently influence the thermal behavior. For example, the Nusselt number and the pressure drop are increasing by nearly a factor of 2 compared a height of 1 um.

The rough coating 13 can improve the heat transfer efficiency as well when using a coating with a dendritic, rough, needle-shaped and/or porous structure of 5-30 um thickness, for example. In comparison with a conventional unmodified pin-fin baseplate, a heat transfer coefficient provided by the baseplate 1 can be enhanced that results in a reduction of the thermal resistance, which allows losses being higher or a current capability being larger. The baseplate 1 itself can be made of copper, aluminum or a corresponding alloy, but also from a composite material like aluminum-silicon-carbide (AlSiC) .

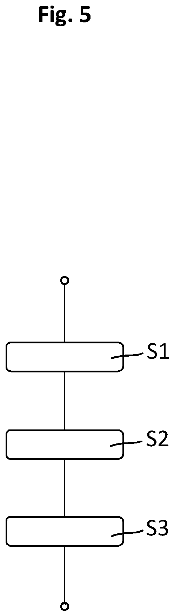

Steps of a corresponding manufacturing method to form the baseplate 1 can follow the flow chart as shown in Figure 5. In a step S1 the lower part 10 with the cooling pin-fins 11 are provided which form the cooling structure.

In a step S2 the upper part 20 is provided and the upper part 20 and the lower part 10 are coupled together. The upper part 20 and the lower part 10 can form separate part or they form adjacent portions made from one piece such that both the upper part 20 and the lower part 10 are provided in one step and they do not have to be coupled with each other.

In a step S3 the given surface structure on the cooling pins-fins 11 is formed by machining such that it includes a mean roughness Ra > 1 um and/or a plurality of protrusions with a respective height H of 2 um or more along the surface normal A. The machining and preparation of a rough surface can be done by etching, grinding, sandblasting, laser irradiation, coating and/or any other applicable process to form the desired roughness. A machining of the cooling structure can be also done before mounting it to the upper part 20. For instances, the roughness is prepared by forming the protrusions 14 with a minimum height of at least 2 um and a distance D or pitch P of at least 10 um. The protrusions 14 maybe formed regularly distributed over the circumferential side surfaces 12 of the pin-fins 11 with a triangular or rectangular shape in view of a respective cross section. These structures may be prepared by etching, shaving, laser structuring or any other applicable process. The protrusions 14 can cover a portion on the respective side surface 12 of the pin-fin 11. The protrusions 14 can partially or completely surround the respective pin-fin 11 such that they form a ring enclosing the respective pin-fin 11. Protrusions 14 and/or roughness may be also available on front or bottom surfaces of ribs or pin-fins 11 facing away from the upper part 20.

The embodiments shown in or described by the figures 1 to 5 as stated represent exemplary embodiments of the improved baseplate 1 and the manufacturing method for; therefore, they do not constitute a complete list of all embodiments. Actual arrangements and methods may vary from the embodiments shown in terms of baseplates, for example.

### Reference signs

- 1: baseplate
- 10: lower part of the baseplate
- 11: pin-fin
- 12: surface of the pin-fin
- 13: rough coating
- 14: protrusion
- 20: upper part of the baseplate
- 22: bottom surface of the upper part
- 30: power module

- A: direction of surface normal of the pin-fin
- B: direction of lateral extension of the pin-fin
- S(i): steps of a method for manufacturing a baseplate

## Claims

1. A baseplate (1) for a power module (30), comprising:
- a lower part (10) that is configured to be in contact with a coolant during operation of the power module (30),
- an upper part (20) that is coupled to the lower part (10), and
- a cooling structure (11) formed at the lower part (10) facing away from the upper part (20), wherein the cooling structure (11) comprises a surface (12) with a given surface structure (13, 14) including a mean roughness RA > 1 µm and a plurality of protrusions with a rectangular or triangular edged shape with respect to a cross section perpendicular to a surface normal (A) and with a respective height (H) of 2 µm or more with respect to the surface normal (A) perpendicular to the surface (12) of the cooling structure (11), wherein the cooling structure (11) further comprises at least one of a plurality of cooling pin-fins (11) and cooling ribs, and wherein the upper part (20) comprises a bottom surface (22) facing the lower part (10) and the given surface structure (13, 14) is formed on the bottom surface (22) and on at least one of the pin-fins (11) and the ribs.

2. The baseplate (1) according to claim 1, wherein the mean roughness Ra and/or the plurality of protrusions with a respective height (H) of 2 µm or more are formed by means of at least one of etching, grinding, sandblasting and laser irradiation.

3. The baseplate (1) according to any one of the preceding claims, wherein the given surface structure comprises a coating (13) such that the coated surface (12) of the cooling structure (11) comprises the mean roughness Ra > 1 µm.

4. The baseplate (1) according to claim 3, wherein the coating (13) comprises at least one of particles, porous material, needle-shaped material, dendritic shape material and structuring and partially or completely covers the cooling structure (11).

5. The baseplate (1) according to any one of the preceding claims, wherein the given surface structure comprises a plurality of protrusions (14) with a respective height (H) of 2 µm or more, wherein a pitch (P) between respective centers of two adjacent protrusions (14) has a value of 10 µm or more with respect to a lateral direction (B) perpendicular to the surface normal (A).

6. The baseplate (1) according to any one of the preceding claims, wherein the protrusions (14) are formed irregularly distributed over the surface (12) of the cooling structure (11) .

7. The baseplate (1) according to any one of the preceding claims, wherein the given surface structure (13, 14) comprises at least one of a mean roughness Ra > 2 µm and a plurality of protrusions with a respective height (H) of 4 µm or more.

8. The baseplate (1) according to any one of the preceding claims, comprising a material made from at least one of copper, aluminum, copper alloy, aluminum alloy, aluminum silicon carbide and magnesium silicon carbide.

9. A semiconductor power module (30), comprising:
- a baseplate (1) according to any one of the preceding claims, and
- electronics, that is coupled to the upper part (20) of the baseplate (1).

10. A method for manufacturing a baseplate (1) for a power module (30), comprising:
- providing a lower part (10) with a cooling structure (11) that is configured to be in contact with a coolant during operation of the power module (30), wherein the cooling structure (11) comprises at least one of a plurality of cooling pin-fins (11) and cooling ribs,
- providing an upper part (20) coupled to the lower part (10), wherein the upper part (20) comprises a bottom surface (22) facing the lower part (10), and
- forming a given surface structure (13, 14) on the cooling structure (11) including a mean roughness Ra > 1 µm and a plurality of protrusions with a rectangular or triangular edged shape with respect to a cross section perpendicular to a surface normal (A) and with a respective height (H) of 2 µm or more with respect to the surface normal (A) perpendicular to a surface (12) of the cooling structure (11) such that the given surface structure (13, 14) is formed on the bottom surface (22) and on at least one of the pin-fins (11) and the ribs.

11. The method according to claim 10, wherein forming the given surface structure (13, 14) on the cooling structure (11) comprises machining the surface (12) by means of at least one of etching, grinding, sandblasting and laser irradiating.

12. The method according to claim 10 or 11, wherein forming the given surface structure (13, 14) on the cooling structure (11) comprises machining the surface (12) by means of coating the surface (12) partially or completely with a given coating material such that the coated surface (12) comprises the mean roughness Ra > 1 µm.

## Patentansprüche

1. Grundplatte (1) für ein Leistungsmodul (30), umfassend:
- einen unteren Abschnitt (10), der konfiguriert ist, sich während des Betriebs des Leistungsmoduls (30) mit einem Kühlmittel in Kontakt zu befinden,
- einen oberen Abschnitt (20), der mit dem unteren Abschnitt (10) gekoppelt ist, und
- eine Kühlstruktur (11), die am unteren Abschnitt (10) gebildet ist, wobei sie vom oberen Abschnitt (20) abgewandt ist, wobei die Kühlstruktur (11) eine Fläche (12) mit einer gegebenen Oberflächenstruktur (13, 14) umfasst, die eine mittlere Rauigkeit RA > 1 um und mehrere Vorsprünge mit einer rechtwinkligen oder dreieckigen, kantigen Form in Bezug auf einen Querschnitt senkrecht zu einer Oberflächennormalen (A) und mit einer jeweiligen Höhe (H) von 2 µm oder größer in Bezug auf die Oberflächennormale (A) senkrecht zur Fläche (12) der Kühlstruktur (11) enthält, wobei die Kühlstruktur (11) ferner mehrere Kühlstiftlamellen(11) und/oder Kühlrippen umfasst und wobei der obere Abschnitt (20) eine untere Fläche (22) umfasst, die dem unteren Abschnitt (10) zugewandt ist, und die gegebene Oberflächenstruktur (13, 14) auf der unteren Fläche (22) und auf den Stiftlamellen (11) und/oder den Rippen gebildet ist.

2. Grundplatte (1) nach Anspruch 1, wobei die mittlere Rauigkeit Ra und/oder die mehreren Vorsprünge mit einer jeweiligen Höhe (H) von 2 µm oder größer mittels Ätzen und/oder Schleifen und/oder Sandstrahlen und/oder Laserbestrahlung gebildet werden.

3. Grundplatte (1) nach einem der vorhergehenden Ansprüche, wobei die gegebene Oberflächenstruktur eine Beschichtung (13) aufweist, derart, dass die beschichtete Fläche (12) der Kühlstruktur (11) die mittlere Rauigkeit Ra > 1 um umfasst.

4. Grundplatte (1) nach Anspruch 3, wobei die Beschichtung (13) Teilchen und/oder ein poröses Material und/oder ein nadelförmiges Material und/oder ein Material mit dendritischer Form und Strukturierung umfasst und die Kühlstruktur (11) teilweise oder vollständig abdeckt.

5. Grundplatte (1) nach einem der vorhergehenden Ansprüche, wobei die gegebene Oberflächenstruktur mehrere Vorsprünge (14) mit einer jeweiligen Höhe (H) von 2 µm oder größer umfasst, wobei eine Schrittweite (P) zwischen den jeweiligen Mitten von zwei benachbarten Vorsprüngen (14) einen Wert von 10 µm oder größer in Bezug auf eine seitliche Richtung (B) senkrecht zur Oberflächennormalen (A) aufweist.

6. Grundplatte (1) nach einem der vorhergehenden Ansprüche, wobei die Vorsprünge (14) unregelmäßig über die Fläche (12) der Kühlstruktur (11) verteilt gebildet sind.

7. Grundplatte (1) nach einem der vorhergehenden Ansprüche, wobei die gegebene Oberflächenstruktur (13, 14) eine mittlere Rauigkeit Ra > 2 um und/oder mehrere Vorsprünge mit einer jeweiligen Höhe (H) von 4 µm oder größer umfasst.

8. Grundplatte (1) nach einem der vorhergehenden Ansprüche, die ein Material umfasst, das aus Kupfer und/oder Aluminium und/oder einer Kupferlegierung und/oder einer Aluminiumlegierung und/oder Aluminiumsiliziumcarbid und/oder Magnesiumsiliziumcarbid hergestellt ist.

9. Halbleiterleistungsmodul (30), das Folgendes umfasst:
- eine Grundplatte (1) nach einem der vorhergehenden Ansprüche und
- Elektronik, die mit dem oberen Abschnitt (20) der Grundplatte (1) gekoppelt ist.

10. Verfahren zum Herstellen einer Grundplatte (1) für ein Leistungsmodul (30), das Folgendes umfasst:
- Bereitstellen eines unteren Abschnitts (10) mit einer Kühlstruktur (11), der konfiguriert ist, sich während des Betriebs des Leistungsmoduls (30) mit einem Kühlmittel in Kontakt zu befinden, wobei die Kühlstruktur (11) mehrere Kühlstiftlamellen (11) und/oder Kühlrippen umfasst,
- Bereitstellen eines oberen Abschnitts (20), der mit dem unteren Abschnitt (10) gekoppelt ist, wobei der obere Abschnitt (20) eine untere Fläche (22) umfasst, die dem unteren Abschnitt (10) zugewandt ist, und
- Bilden einer gegebenen Oberflächenstruktur (13, 14) auf der Kühlstruktur (11), die eine mittlere Rauigkeit Ra > 1 um und mehrere Vorsprünge mit einer rechtwinkligen oder dreieckigen, kantigen Form in Bezug auf einen Querschnitt senkrecht zu einer Oberflächennormalen (A) und mit einer jeweiligen Höhe (H) von 2 µm oder größer in Bezug auf die Oberflächennormale (A) senkrecht zu einer Fläche (12) der Kühlstruktur (11) enthält, derart, dass die gegebene Oberflächenstruktur (13, 14) auf der unteren Fläche (22) und auf den Stiftlamellen (11) und/oder den Rippen gebildet ist.

11. Verfahren nach Anspruch 10, wobei das Bilden der gegebenen Oberflächenstruktur (13, 14) auf der Kühlstruktur (11) das maschinelle Bearbeiten der Fläche (12) mittels Ätzen und/oder Schleifen und/oder Sandstrahlen und/oder Laserbestrahlung umfasst.

12. Verfahren nach Anspruch 10 oder 11, wobei das Bilden der gegebenen Oberflächenstruktur (13, 14) auf der Kühlstruktur (11) das maschinelle Bearbeiten der Fläche (12) mittels Beschichten der Fläche (12) teilweise oder vollständig mit einem gegebenen Beschichtungsmaterial umfasst, derart, dass die beschichtete Fläche (12) die mittlere Rauigkeit Ra > 1 um umfasst.

## Revendications

1. Plaque (1) de base pour un module (30) de puissance, comportant :
- une partie inférieure (10) qui est configurée pour être en contact avec un agent de refroidissement pendant le fonctionnement du module (30) de puissance,
- une partie supérieure (20) qui est couplée à la partie inférieure (10), et
- une structure (11) de refroidissement formée à la partie inférieure (10) orientée à l'opposé de la partie supérieure (20), la structure (11) de refroidissement comportant une surface (12) dotée d'une structure (13, 14) de surface donnée incluant une rugosité moyenne Ra > 1 um et une pluralité de protubérances dotées d'une forme à bords rectangulaires ou triangulaires par rapport à une section droite perpendiculaire à une normale (A) à la surface et d'une hauteur respective (H) de 2 um ou plus par rapport à la normale (A) à la surface perpendiculaire à la surface (12) de la structure (11) de refroidissement, la structure (11) de refroidissement comportant en outre une pluralité d'ailettes aciculaires (11) de refroidissement et/ou des nervures de refroidissement, et la partie supérieure (20) comportant une surface inférieure (22) qui fait face à la partie inférieure (10) et la structure (13, 14) de surface donnée étant formée sur la surface inférieure (22) et sur les ailettes aciculaires (11) et/ou les nervures.

2. Plaque (1) de base selon la revendication 1, la rugosité moyenne Ra et/ou la pluralité de protubérances d'une hauteur respective (H) de 2 um ou plus étant formées au moyen d'au moins un procédé parmi une gravure, un meulage, un sablage et une irradiation par laser.

3. Plaque (1) de base selon l'une quelconque des revendications précédentes, la structure de surface donnée comportant un revêtement (13) tel que la surface revêtue (12) de la structure (11) de refroidissement présente la rugosité moyenne Ra > 1 um.

4. Plaque (1) de base selon la revendication 3, le revêtement (13) comportant des particules, un matériau poreux, un matériau en forme d'aiguilles, un matériau de forme dendritique et/ou une structuration, et recouvrant partiellement ou entièrement la structure (11) de refroidissement.

5. Plaque (1) de base selon l'une quelconque des revendications précédentes, la structure de surface donnée comportant une pluralité de protubérances (14) d'une hauteur respective (H) de 2 um ou plus, un pas (P) entre des centres respectifs de deux protubérances (14) adjacentes ayant une valeur de 10 um ou plus par rapport à une direction latérale (B) perpendiculaire à la normale (A) de surface.

6. Plaque (1) de base selon l'une quelconque des revendications précédentes, les protubérances (14) étant formées de manière irrégulièrement répartie sur la surface (12) de la structure (11) de refroidissement.

7. Plaque (1) de base selon l'une quelconque des revendications précédentes, la structure (13, 14) de surface donnée présentant une rugosité moyenne Ra > 2 um et/ou une pluralité de protubérances d'une hauteur respective (H) de 4 µm ou plus.

8. Plaque (1) de base selon l'une quelconque des revendications précédentes, comportant un matériau formé d'au moins un constituant parmi du cuivre, de l'aluminium, un alliage de cuivre, un alliage d'aluminium, de l'aluminium-carbure de silicium et du magnésium-carbure de silicium.

9. Module (30) de puissance à semiconducteur, comportant :
- une plaque (1) de base selon l'une quelconque des revendications précédentes, et
- une électronique qui est couplée à la partie supérieure (20) de la plaque (1) de base.

10. Procédé de fabrication d'une plaque (1) de base pour un module (30) de puissance, comportant les étapes consistant à :
- mettre en place une partie inférieure (10) dotée d'une structure (11) de refroidissement qui est configurée pour être en contact avec un agent de refroidissement pendant le fonctionnement du module (30) de puissance, la structure (11) de refroidissement comportant une pluralité d'ailettes aciculaires (11) de refroidissement et/ou des nervures de refroidissement,
- mettre en place une partie supérieure (20) couplée à la partie inférieure (10), la partie supérieure (20) comportant une surface inférieure (22) qui fait face à la partie inférieure (10), et
- former une structure (13, 14) de surface donnée sur la structure (11) de refroidissement incluant une rugosité moyenne Ra > 1 um et une pluralité de protubérances dotées d'une forme à bords rectangulaires ou triangulaires par rapport à une section droite perpendiculaire à une normale (A) à la surface et d'une hauteur respective (H) de 2 um ou plus par rapport à la normale (A) à la surface perpendiculaire à une surface (12) de la structure (11) de refroidissement de telle façon que la structure (13, 14) de surface donnée soit formée sur la surface inférieure (22) et sur les ailettes aciculaires (11) et/ou les nervures.

11. Procédé selon la revendication 10, la formation de la structure (13, 14) de surface donnée sur la structure (11) de refroidissement comportant l'usinage de la surface (12) au moyen d'au moins un procédé parmi une gravure, un meulage, un sablage et une irradiation par laser.

12. Procédé selon la revendication 10 ou 11, la formation de la structure (13, 14) de surface donnée sur la structure (11) de refroidissement comportant l'usinage de la surface (12) en revêtant la surface (12) partiellement ou entièrement d'un matériau de revêtement donné de telle façon que la surface revêtue (12) présente la rugosité moyenne Ra > 1 µm.
